# EUROPÄISCHE PATENTSCHRIFT

(11) **EP 1 214 788 B1**
(45) Veröffentlichungstag und Bekanntmachung des Hinweises auf die Patenterteilung: **26.03.2003**
(21) Anmeldenummer: 00967591.9
(22) Anmeldetag: 19.09.2000
(51) Int. Cl.: H03K 19/003, G06F 1/10, G01R 31/319, G10F 1/10, H03K 5/15

(54) **INTEGRIERTER SCHALTKREIS MIT ZUMINDEST ZWEI TAKTSYSTEMEN**
INTEGRATED CIRCUIT COMPRISING AT LEAST TWO CLOCK SYSTEMS
CIRCUIT INTEGRE COMPRENANT AU MOINS DEUX SYSTEMES D'HORLOGE

(30) Priorität: 22.09.1999 DE 19945421
(43) Veröffentlichungstag der Anmeldung: 19.06.2002
(73) Patentinhaber: SIEMENS AKTIENGESELLSCHAFT, 80333 München (DE)
(72) Erfinder: GHAMESHLU, Majid, A-1110 Wien (AT); KRAUSE, Karlheinz, 82152 Planegg (DE)
(86) Internationale Anmeldenummer: DE0003258
(87) Internationale Veröffentlichungsnummer: WO01022588

(56) Entgegenhaltungen:
- EP-A- 0 962 851
- US-A- 5 329 188
- US-A- 5 578 945
- KEEZER D C ET AL: "CLOCK DISTRIBUTION STRATEGIES FOR WSI: A CRITICAL SURVEY" PROCEEDINGS OF THE ANNUAL INTERNATIONAL CONFERENCE ON WAFER SCALE INTEGRATION (FROM 1996 PROCEEDINGS OF THE INTERNATIONAL CONFERENCE ON INNOVATIVE SYSTEMS IN SILICON),US,NEW YORK, IEEE, Bd. CONF. 3, 29. Januar 1991 (1991-01-29), Seiten 277-283, XP000215208

## Beschreibung

Die Erfindung bezieht sich auf einen integrierten Schaltkreis mit zumindest zwei Taktsystemen, bei welchen der entsprechende Takt, ausgehend von einem Takteingang durch Taktbäume zu einzelnen Schaltelementen oder -blöcken weiterleitbar ist, sowie mit zumindest einem gesteuerten Schalter mit dessen Hilfe für ausgewählte Betriebszustände ein einziger gemeinsamer Takt an alle Taktbäume legbar ist, wobei zumindest einem ersten Taktbaum eine PLL-Einheit vorgeschaltet ist und zur Bildung einer Phasenregelschleife ein Ausgang dieses Taktbaumes mit einem Eingang der PLL-Einheit verbunden ist.

Integrierte Schaltkreise für digitale Anwendungen enthalten sogenannte Taktbäume ("clock trees"). Dabei handelt es sich um eine baumartige Struktur zur Weiterleitung eines Eingangstaktes an die einzelnen Schaltelemente, üblicherweise Flipflops, des Schaltkreises. Die Gestalt der Taktbäume hängt von der Anzahl der Flipflops des Teilsystems, z.B. eines ASICs, und von der angewendeten Topologie ab. Je nach Anzahl seiner Stufen und seines Aufbaues kann ein Taktbaum in einem ASIC z.B. 2000, 20 000, 40 000, usf. Flipflops besitzen.

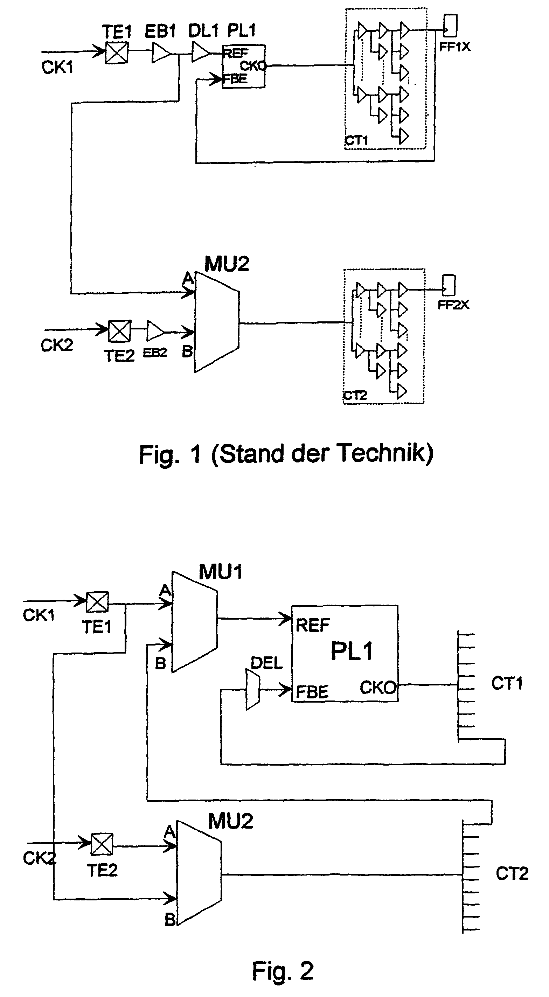

Fig. 1 zeigt die Struktur eines ASIC nach dem Stand der Technik mit zwei Takteingängen TE1, TE2 für zwei Taktbäume CT1, CT2. Der erste Takt CK1 wird von dem Takteingang TE1 über einen Eingangspuffer EB1, ein Verzögerungselement DL1 und eine PLL-Einheit PL1 dem ersten Taktbaum CT1 zugeführt. Der Takt wird gegebenenfalls über weitere Puffer in einzelnen Stufen den entsprechenden Registerstufen bzw. Flipflops zugeführt. Für den Taktbaum CT1 ist an dessen Ende stellvertretend ein Flipflop FF1x, für den Taktbaum CT2 ein Flipflop FF2x eingezeichnet. Ein zweiter Takt CK2 ist von dem Takteingang TE2 über einen Eingangspuffer EB2 und einen gesteuerten Schalter MU2 dem zweiten Taktbaum CT2 zugeführt, wobei zu einem weiteren Eingang des Schalters MU2 auch der erste Takt CK1 geführt ist.

Für bestimmte Applikationen, insbesondere den sogenannten "Built In Self Test" (=BIST) werden bei mehr als einem Taktsystem in einem ASIC die Taktsysteme in ein einziges übergeführt. Dabei tritt jedoch das.Problem auf, dass die Laufzeiten von einem Takteingang des ASIC zu den Flipflop-Takteingängen der Teil-Taktsysteme unterschiedlich sind, da die Taktbäume an sich Differenzen aufweisen. Man löst dieses Problem nach dem Stand der Technik durch Verwendung von Verzögerungselementen, wobei hier auf das Element DL1 in Fig. 1 verwiesen wird. Durch solche Verzögerungselemente wird der Pfad des schnelleren Taktbaumes - in Fig. 1 der Taktbaum CT1 - an den langsamsten Pfad angepasst. Nachteilig an dieser Lösung ist, dass die internen Verzögerungselemente einerseits einer Toleranz und Prozessvariation unterliegen und andererseits im Sinne eines Bypass abschaltbar sein müssen, wenn im normalen Betrieb des Schaltkreises die kurze Laufzeit des betreffenden Taktbaumes erforderlich ist.

Eine Aufgabe der Erfindung liegt in der Schaffung eines integrierten Schaltkreises, bei welchem für bestimmte Betriebszustände ein gemeinsamer Takt an alle Taktbäume so legbar ist, dass die oben genannten Probleme mit Laufzeiten, etc. nicht auftreten.

Diese Aufgabe wird mit einem integrierten Schaltkreis der eingangs genannten Art gelöst, bei welchem erfindungsgemäß jedem Taktbaum ein gesteuerter Schalter zugeordnet ist und die Schalter in den ausgewählten Betriebszuständen so angesteuert sind, dass der gemeinsame Takt lediglich einem letzten Taktbaum zugeführt und ein Ausgang dieses Taktbaumes mit dem anderen Eingang der PLL-Einheit des zumindest ersten Taktbaumes verbunden ist.

Da für den Normalbetrieb eines ASIC zur Laufzeitkompensation eines Taktbaumes in vielen Fällen eine PLL-Einheit vorgesehen ist, ist diese Einheit ohnedies oft vorhanden, und man benötigt lediglich für den ersten Taktbaum bzw. für weitere Taktbäume einen bzw. mehrere gesteuerte Schalter (Multiplexer). Dabei wird auf einfache Weise eine dynamische Anpassung der Durchlaufzeit erreicht, und die Prozessvariation lässt sich eliminieren.

Bei einer vorteilhaften Variante der Erfindung ist vorgesehen, dass zwischen den Ausgang des zumindest ersten Taktbaumes und den einen Eingang der PLL-Einheit ein Verzögerungsbaustein gelegen ist, dessen Verzögerung jener eines gesteuerten Schalters entspricht. Hierdurch kann die in den gesteuerten Schaltern aufgetretene Verzögerung bei Bedarf für die Phasenregelschleife ausgeglichen werden. Die entsprechende Realisierung gestaltet sich besonders einfach, falls der Verzögerungsbaustein ein den umschaltbaren Schaltern entsprechender, nicht angesteuerter Schalter ist.

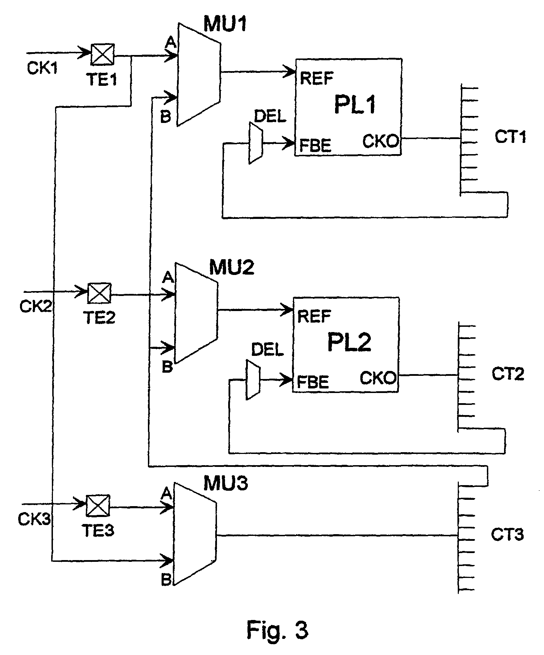

Die Erfindung samt weiteren Vorteilen ist im folgenden unter Bezugnahme auf die Zeichnungen näher erläutert. In diesen zeigen
■ Fig. 1 einen integrierten Schaltkreis nach dem Stand der Technik,
■ Fig. 2 einen integrierten Schaltkreis gemäß der Erfindung in einer ersten Ausführungsform mit zwei Taktbäumen, und
■ Fig. 3 eine weitere Ausführungsform der Erfindung mit drei Taktbäumen.

Fig. 2 ist als auszugsweises Blockschaltbild eines ASIC zu verstehen, wie es etwas genauer, aber immer noch schematisch in Fig. 1 zum Stand der Technik dargestellt wurde, hier jedoch ergänzt um die erfindungsgemäßen Merkmale.

Der ASIC besitzt zwei Taktbäume CT1, CT2, zwei Takteingänge TE1, TE2, über welche im Normalbetrieb ein erster Takt CK1 bzw. ein zweiter Takt CK2 über einen ersten bzw. zweiten gesteuerten Schalter MU1 bzw. MU2 einem ersten bzw. zweiten Taktbaum CT1 bzw. CT2 zugeführt ist. In diesem Normalbetrieb ist bei jedem Schalter ihr erster Eingang "A" durchgeschaltet. Von dem Takteingang TE1 führt überdies eine Leitung zu dem zweiten Eingang "B" des zweiten gesteuerten Schalters MU2.

Der Ausgang des ersten Schalters MU1 führt nicht direkt zu dem ersten Taktbaum CT1, sondern über eine PLL-Einheit PL1. Der Takt ist dabei dem Referenzeingang REF der Einheit PL1 zugeführt, wogegen ihr zweiter Eingang FBE mit einem Ausgang des Taktbaumes TE1 über ein Verzögerungsglied DEL verbunden ist. Aufgabe des nicht unbedingt erforderlichen Verzögerungsgliedes DEL ist es, eine in dem gesteuerten Schalter MU1 auftretende Taktverzögerung auszugleichen. Die Verzögerungszeit des Gliedes DEL soll daher jener des Schalters MU1 entsprechen, wobei genau aus diesem Grunde in der Praxis als Verzögerungsglied DEL ein "stillgelegter" Schalter der gleichen Art wie der Schalter MU1 verwendet wird.

Wie aus Fig. 2 weiters ersichtlich, ist ein Ausgang des letzten Taktbaumes des ASIC hier naturgemäß des zweiten Taktbaumes CT2 zu dem zweiten Eingang "B" des ersten gesteuerten Schalters MU1 geführt, was im Normalbetrieb keinerlei Auswirkung hat. Werden jedoch für z.B. einen Selbsttest ("BIST") die beiden Schalter MU1, MU2 auf je ihren Eingang "B" umgeschaltet, so wird nur noch der erste Takt CK1 als gemeinsamer Takt dem ASIC wirksam zugeführt, und zwar über den zweiten Schalter MU2 und den zweiten Taktbaum CT2 zu dem zweiten Eingang "B" des ersten gesteuerten Schalters MU1. Von hier gelangt der Takt zu dem Referenzeingang REF der PLL-Einheit PL1. Der über den gesamten zweiten Taktbaum CT2 geführte Takt dient somit nun als Referenztakt für die Phasenregelschleife PL1-CT1-DEL.

Bei der Variante nach Fig. 3 sind drei Taktbäume TE1, TE2, TE3 vorhanden, die im Normalbetrieb, ausgehend von Takteingängen TE1, TE2, TE3 je einen von drei Takten CK1, CK2, CK3 erhalten. Wie gemäß Fig. 2 erfolgt die Taktzuführung über gesteuerte Schalter MU1, MU2, MU3 und - für die beiden ersten Taktbäume CT1, CT2 - über eine PLL-Einheit PL1 bzw. PL2. Der Ausgangstakt der ersten beiden Taktbäume CT1, CT2 wird dabei über je ein Verzögerungsglied DEL den Rückkopplungseingängen FBE der PLL-Einheiten PL1, PL2 zugeführt.

In Fortführung des in Fig. 2 erläuterten Erfindungsgedanken wird bei speziellen Betriebszuständen, wie bei einem "BIST"-Betrieb durch Umschalten der drei Schalter MU1, MU2, MU3 nur noch der ersten Takt CK1 verwendet. Er wird dabei über den dritten Taktbaum TE3 als Referenztakt den Referenzeingängen REF der PLL-Einheiten PL1, PL2 zugeführt, sodass nun alle drei Taktbäume CT1, CT2, CT3 in der erwünschen Weise gemeinsam getaktet sind.

Es ist klar, dass die Erfindung analog bei n Taktsystemen eingesetzt werden kann, wobei dann (n-1) PLL-Einheiten benötigt werden. In allen Fällen ist die dynamische Anpassung der Durchlaufzeit gesichert und die Prozessvariation kompensiert.

## Patentansprüche

1. Integrierter Schaltkreis mit zumindest zwei Taktsystemen, bei welchen der entsprechende Takt, ausgehend von einem Takteingang (TE1, TE2) durch Taktbäume (CT1, CT2, CT3) zu einzelnen Schaltelementen oder -blöcken (FFi) weiterleitbar ist, sowie mit zumindest einem gesteuerten Schalter (MU1, MU2, MU3) mit dessen Hilfe für ausgewählte Betriebszustände ein einziger gemeinsamer Takt an alle Taktbäume legbar ist, wobei zumindest einem ersten Taktbaum (CT1, CT2) eine PLL-Einheit (PL1) vorgeschaltet ist und zur Bildung einer Phasenregelschleife (PLL) ein Ausgang dieses Taktbaumes mit einem Eingang der PLL-Einheit verbunden ist,
**dadurch gekennzeichnet,**
**dass**, jedem Taktbaum (CT1, CT2, CT3) ein gesteuerter Schalter (MU1, MU2, MU3) zugeordnet ist und die Schalter in den ausgewählten Betriebszuständen so angesteuert sind, dass der gemeinsame Takt lediglich einem letzten Taktbaum (CT3) zugeführt und ein Ausgang dieses Taktbaumes mit dem anderen Eingang der PLL-Einheit des zumindest ersten Taktbaumes (CT1, CT2) verbunden ist.

2. Schaltkreis nach Anspruch 1,
**dadurch gekennzeichnet, dass** zwischen den Ausgang des zumindest ersten Taktbaumes (CT1, CT2) und den einen Eingang der PLL-Einheit (PLL) ein Verzögerungsbaustein (DEL) gelegen ist, dessen Verzögerung jener eines gesteuerten Schalters (MU1) entspricht.

3. Schaltkreis nach Anspruch 2,
**dadurch gekennzeichnet, dass** der Verzögerungsbaustein ein den umschaltbaren Schaltern (MU1, MU2) entsprechender, nicht angesteuerter Schalter (DEL) ist.

## Claims

1. Integrated circuit having at least two clock systems in which the appropriate clock signal, starting from a clock input (TE1, TE2), can be forwarded through clock trees (CT1, CT2, CT3) to individual switching elements or switching blocks (FFi), and having at least one controlled switch (MU1, MU2, MU3) which, for selected operating states, can be used to apply a single common clock signal to all clock trees, where at least a first clock tree (CT1, CT2) has a PLL unit (PL1) connected upstream of it, and an output of this clock tree is connected to an input of the PLL unit in order to form a phase locked loop (PLL),
**characterized**
**in that** each clock tree (CT1, CT2, CT3) has an associated controlled switch (MU1, MU2, MU3) and the switches are actuated in the selected operating states such that the common clock signal is supplied only to a last clock tree (CT3), and an output of this clock tree is connected to the other input of the PLL unit for the at least first clock tree (CT1, CT2).

2. Circuit according to Claim 1,
**characterized in that** a delay module (DEL) whose delay corresponds to that of a controlled switch (MU1) is connected between the output of the at least first clock tree (CT1, CT2) and one input of the PLL unit (PLL).

3. Circuit according to Claim 2,
**characterized in that** the delay module is an unactuated switch (DEL) corresponding to the switchable switches (MU1, MU2).

## Revendications

1. Circuit intégré comprenant au moins deux systèmes d'horloge dans lesquels l'horloge correspondante peut être transmise à partir d'une entrée d'horloge (TE1, TE2) par des arbres d'horloge (CT1, CT2, CT3) à différents éléments ou blocs de commutation (FFi), et comprenant au moins un commutateur piloté (MU1, MU2, MU3) à l'aide duquel, pour des états de fonctionnement sélectionnés, une seule horloge commune peut être appliquée à tous les arbres d'horloge, une unité PLL (PL1) étant placée en amont au moins d'un premier arbre d'horloge (CT1, CT2) et pour former une boucle à verrouillage de phase (PLL), une sortie de cet arbre d'horloge est reliée à une entrée de l'unité PLL,
**caractérisé en ce que**
à chaque arbre d'horloge (CT1, CT2, CT3) est associé un commutateur piloté (MU1, MU2, MU3) et **en ce que** les commutateurs, dans les états de fonctionnement sélectionnés, sont pilotés de telle manière que l'horloge commune est amenée uniquement à un dernier arbre d'horloge (CT3) et qu'une sortie de cet arbre d'horloge est reliée à l'autre entrée de l'unité PLL dudit au moins premier arbre d'horloge (CT1, CT2).

2. Circuit selon la revendication 1, **caractérisé en ce qu'**un module de retard (DEL) est placé entre la sortie dudit au moins premier arbre d'horloge (CT1, CT2) et de ladite une entrée de l'unité PLL (PLL), dont le retard correspond à celui d'un commutateur piloté (MU1).

3. Circuit selon la revendication 2, **caractérisé en ce que** le module de retard est un commutateur non piloté (DEL) correspondant aux commutateurs à bascule (MU1, MU2).
